# EUROPÄISCHE PATENTSCHRIFT

(11) **EP 0 342 496 B1**
(45) Veröffentlichungstag und Bekanntmachung des Hinweises auf die Patenterteilung: **29.12.1993**
(21) Anmeldenummer: 89108373.5
(22) Anmeldetag: 10.05.1989
(51) Int. Cl.: G03F 7/004

(54) **Strahlungsempfindliches Gemisch und Verfahren zur Herstellung von Reliefmustern**
Light-sensitive composition, and process for the formation of relief patterns
Composition photosensible et procédé pour la fabrication d'images en relief

(30) Priorität: 19.05.1988 DE 3817011
(43) Veröffentlichungstag der Anmeldung: 23.11.1989
(73) Patentinhaber: BASF Aktiengesellschaft, 67063 Ludwigshafen (DE)
(72) Erfinder: Schwalm, Reinhold, Dr., D-6706 Wachenheim (DE); Binder, Horst, D-6840 Lampertheim (DE)

(56) Entgegenhaltungen:
- DE-A- 3 628 046
- JP-A-62 038 450
- JOURNAL OF IMAGING TECHNOLOGY. vol. 11, no. 4, August 1985, SPRINGFIELD US Seiten 146 - 157; S.P.Papas: "Photogeneratiom of Acid : Part 6 - A Review of Basic Principles for Resist Imaging Applications "

## Beschreibung

Die Erfindung betrifft positiv arbeitende strahlungsempfindliche Gemische, die ein wäßrig-alkalisch lösliches Bindemittel, welches bis zu 40 % hydrophobe Comonomereinheiten einpolymerisiert enthält, und eine Verbindung, die mindestens eine durch Säure spaltbare Bindung enthält und unter Einwirkung von Strahlung eine starke Säure bildet, wobei die Löslichkeit der Verbindung in einem alkalischen Lösungsmittel durch die Einwirkung der Säure erhöht wird, enthalten. Diese Gemische sind sensitiv gegenüber UV-, Elektronen- und Röntgenstrahlen und eignen sich besonders als Resistmaterialien und zur Herstellung von Reliefmustern.

Positiv arbeitende strahlungsempfindliche Gemische sind bekannt. Besonders positiv arbeitende Resistmaterialien, die o-Chinondiazide in wäßrigalkalisch löslichen Bindemitteln, z.B. Novolaken enthalten, werden kommerziell eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärphotoreaktion eine Spezies erzeugen, die dann unabhängig von der Strahlung eine katalytische Sekundärreaktion auslösen, sind beschrieben. In der US-A-3 915 706 werden beispielsweise Photoinitiatoren beschrieben, die eine starke Säure erzeugen, die dann in einer Sekundärreaktion säurelabile Gruppen, wie Polyaldehydgruppierungen spalten.

Weiterhin sind strahlungsempfindliche Gemische auf Basis von säurespaltbaren Verbindungen bekannt, die als Bindemittel ein wäßrig-alkalisch lösliches Polymer, sowie eine Verbindung die photochemisch eine starke Säure bildet und eine weitere Verbindung mit durch Säure spaltbaren Bindungen, die durch die Einwirkung der Säure ihre Löslichkeit in einem alkalischen Entwickler erhöhen, enthalten (vgl. z.B. DE-A-3 406 927). Als photochemisch eine starke Säure bildende Verbindungen werden Diazonium-, Phosphonium-, Sulfonium- und Iodonium-, sowie Halogenverbindungen genannt. Die Verwendung dieser Oniumsalze als photochemische Säurespender in Resistmaterialien ist z.B. auch aus US-A-4 491 628 bekannt. Einen Überblick über die Anwendung von Oniumsalzen in Resistmaterialien gibt Crivello in Org. Coatings and Appl. Polym. Sci., 48, S. 65-69 (1985). Nachteilig bei diesen Photoinitiatoren ist, daß durch die Einwirkung der Strahlung neben der gebildeten Säure keine weiteren Photoprodukte entstehen, die eine Erhöhung der Löslichkeit im alkalischen Entwickler bewirken. Weiterhin benötigen diese Gemische zwingend drei Komponenten.

Strahlungsempfindliche Gemische von Polymeren mit säurelabilen Seitengruppen und photochemischen Säurespendern sind z.B. aus US-A-4 491 628 und FR-A-2 570 844 bekannt. Diese polymeren Bindemittel sind jedoch hydrophob und werden erst nach der Belichtung alkalilöslich. Die Polymeren sind also so ausgelegt, daß durch die Einwirkung von Säure eine große Differenzierung der Polarität erhalten wird. Sie enthalten daher wiederkehrende Einheiten mit säurelabilen Gruppen, so daß die Abspaltung dieser Gruppen einen großen Massenverlust bedingt.

Aus DE-A-3 628 046 und JP-A-62 038 450 sind strahlungsempfindliche Gemische bekannt, die eine hochmolekulare Verbindung, deren Löslichkeit in einem wäßrig-alkalischen Entwickler durch Einwirkung von Säure erhöht wird, und eine Verbindung, die unter Einwirkung von Strahlung eine starke Säure bildet, enthalten.

In DE-A-3 721 741 werden strahlungsempfindliche Gemische vorgeschlagen, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt. Für bestimmte Anwendungszwecke haben diese Systeme jedoch Nachteile. In diesen Systemen hat die organische Verbindung zwei Aufgaben, nämlich die Löslichkeit des polymeren Bindemittels vor der Belichtung zu reduzieren und nach der Belichtung zu erhöhen und zudem muß die Verbindung strahlungsempfindlich sein. Für bestimmte Anwendungen ist es jedoch vorteilhaft, den Anteil der photoaktiven organischen Verbindung zu reduzieren, z.B. um eine höhere Transparenz im kurzwelligen UV-Gebiet (im Bereich von 250 nm) zu erhalten, so daß die Aufgabe der Löslichkeitsinhibierung durch andere Maßnahmen unterstützt werden muß.

Aufgabe der vorliegenden Erfindung ist es, hochreaktive strahlungsempfindliche Systeme für die Herstellung von Reliefstrukturen zur Verfügung zu stellen, die sich mit wäßrig-alkalischen Lösungen entwickeln lassen und die die Herstellung von lichtempfindlichen Schichten mit hoher Transparenz im kurzwelligen UV ermöglichen, ohne daß übermäßige Massenverluste auftreten.

Überraschenderweise kann diese Aufgabe durch den Einbau von Alkylcarbonatgruppierungen mit 5 bis 9 Kohlenstoffatomen in der Alkylgruppe sehr vorteilhaft gelöst werden.

Gegenstand der vorliegenden Erfindung ist ein strahlungsempfindliches Gemisch, enthaltend
(a) ein in Wasser unlösliches, in wäßrig-alkalischen Lösungen lösliches polymeres Bindemittel und
(b) eine organische Verbindung, deren Löslichkeit in einem wäßrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure bildet, enthält,
das dadurch gekennzeichnet ist, daß das polymere Bindemittel (a) 5 bis 40 Mol.% Monomereneinheiten mit 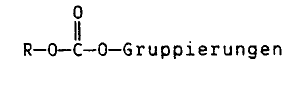
einpolymerisiert bzw. einkondensiert oder die 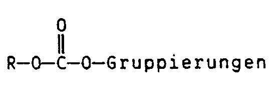
durch polymeranaloge Umsetzung eingeführt enthält, mit der Maßgabe, daß der Rest R 5 bis 9 Kohlenstoffatome enthält, und als organische Verbindung (b) ein Sulfoniumsalz der allgemeinen Formel (I) 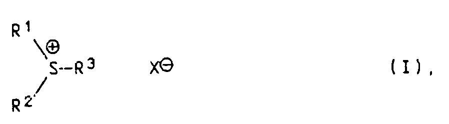
worin R¹, R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält, wobei einer der Reste R¹ bis R³ mit einem oder mehreren weiteren Sulfoniumsalzresten, gegebenenfalls über durch Säure abspaltbare Gruppierungen, verknüpft sein kann, und X^{⊖} ein nichtnukleophiles Gegenion bedeutet, eingesetzt wird.

Bevorzugt sind dabei strahlungsempfindliche Gemische mit polymeren Bindemitteln (a) auf Basis von Polymeren des p-Hydroxistyrols und/oder p-Hydroxi-α-methylstyrols, deren phenolische Hydroxylgruppen zu 5 bis 40 Mol.% durch C₅- bis C₉-Alk(en)yloxicarbonyloxireste ersetzt sind, sowie Novolake auf Basis von p-Kresol und Formaldehyd, worin 5 bis 40 Mol.% der p-Kresoleinheiten durch Gruppierungen der Formel 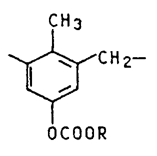
ersetzt sind, und R für einen Alkyl-, Alkenyl-, Alkinyl, Cycloalkyl- oder Cycloalkenylrest mit jeweils 5 bis 9 Kohlenstoffatomen steht.

Gegenstand der vorliegenden Erfindung ist auch ein Verfahren zur Herstellung von Reliefmustern und Reliefbildern, wobei man als lichtempfindliche Beschichtungsmateralien ein erfindungsgemäßes strahlungsempfindliches Gemisch einsetzt.

Vorzugsweise wird nach der Belichtung des strahlungsempfindlichen Gemisches auf Temperaturen zwischen 60 und 120°C erhitzt.

Die erfindungsgemäßen strahlungsempfindlichen Gemische zeichnen sich durch hohe Transparenz im Wellenlängenbereich um 250 nm, hohe Empfindlichkeit gegenüber kurzwelliger UV-Strahlung (< 300 nm) und gute Resistenz gegenüber fluorhaltigen Ätzgasen aus. Sie sind daher ideal für die Anwendung in der Deep/UV-Lithographie geeignet. Die erfindungsgemäßen Polymeren (a) können besonders vorteilhaft als Bindemittel in Photoresisten eingesetzt werden, da sie gute Oberflächenqualität, wenig Abtrag in den unbelichteten Bereichen und Entwicklung ohne auflösungsbegrenzende Quellung ermöglichen.

Zu den Aufbaukomponenten des erfindungsgemäßen Gemisches ist im einzelnen folgendes auszuführen.
a) Als in Wasser unlösliche, in wäßrig-alkalischen Lösungen lösliche polymere Bindemittel kommen bevorzugt phenolische Harze, wie z.B. Novolake, Poly-(p-hydroxistyrole), Poly-(p-hydroxi-α-methylstyrole) oder Copolymere von p-Hydroxistyrol bzw. p-Hydroxi-α-methylstyrol, die seitenständige C₅- bis C₉-Alkylcarbonatgruppen enthalten, in Betracht.
   Beispielsweise können derartige alkylcarbonathaltige Polymere der nachfolgenden allgemeinen Formel (II) 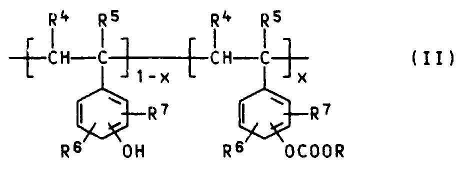 entsprechen, worin R für Alkoholreste der allgemeinen Formel (III) 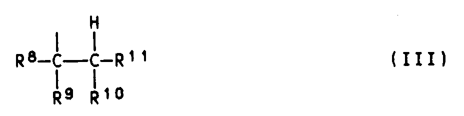 stehen, wobei R⁴ = H, Halogen (z.B. Chlor) oder C₁- bis C₃-Alkyl; R⁵ = H oder C₁- bis C₄-Alkyl; R⁶, R⁷ = H, Halogen (z.B. Chlor), C₁- bis C₄-Alkyl und/oder C₁- bis C₄-Alkoxi; R⁸-R¹¹ = H, Alkyl, Alkenyl oder Alkinyl, mit der Maßgabe, daß die Zahl der Kohlenstoffatome des Restes R zwischen 5 und 9 liegt, wobei auch 2 Reste R⁸-R¹¹ zu einem Ring verknüpft sein können, und x = 0,05-0,4.
   Ebenso eignen sich p-Kresol/Formaldehyd-Novolake, deren p-Kresoleinheiten zu 5 bis 40 Mol.% der Kresoleinheiten durch 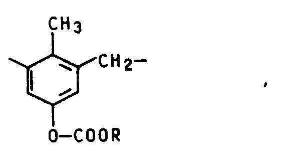 worin R die oben genannte Bedeutung hat, ersetzt sind.
   Bevorzugt sind sterisch anspruchsvolle Alkoholreste R-O- mit 5 bis 9, insbesondere 5 bis 7 Kohlenstoffatomen, die auch ethylenisch oder acetylenisch ungesättigt sein können, wie beispielsweise Cyclohexyl-oxi-, 1-Methyl-cyclohexyl-oxi-, 2-Methyl-3-buten-2-oxi-, 2-Methyl-butan-2-oxi-, 2-Methyl-hexan-2-oxi-, 3-Methyl-1-penten-3-oxi-, 3-Methyl-pentan-3-oxi-, 2-Methyl-pentan-2-oxi-, 3-Methyl-2-butanol und 2-Methyl-3-butin-2-oxi-reste.
   Als Novolake kommen im Prinzip solche in Frage, wie sie z.B. in "Novolak Resins Used in Positiv Resist Systems" von T. Pampalone in Solid State Technology, June 1984, Seite 115-120, beschrieben sind.
   Für spezielle Anwendungen, z.B. für Belichtung im kurzwelligen UV-Gebiet kommen bevorzugt Novolake aus p-Kresol und Formaldehyd in Frage. Diese Novolake können dann z.B. mit Di-t-amyl-dicarbonat in Gegenwart von Kalium-t-butylat in beispielsweise Tetrahydrofuran so umgesetzt werden, daß 5 bis 40 Mol.% der phenolischen Gruppen umgesetzt werden.
   Phenolische Harze auf Basis von Hydroxystyrolen können nach gängigen Methoden radikalisch oder ionisch aus mehreren ungesättigten Monomeren copolymerisiert werden. Ungesättigte Komponenten, welche bevorzugt copolymerisiert werden können, sind beispielsweise substituierte und unsubstituierte Hydroxistyrole, wie p-Hydroxistyrol, m-Hydroxistyrol, p-(2-Methyl-hexan-2-oxi-carbonyloxi-)styrol, p-(t-Amyloxi-carbonyl-oxi-)styrol, p-Hydroxi-α-methyl-styrol oder p-(Cyclohexyloxi-carbonyl-oxi-)-α-methylstyrol.
   Diese erfindungsgemäß einzusetzenden Polymeren auf Basis von Hydroxistyrolen können ebenfalls durch polymeranaloge Umsetzung von z.B. Poly-(p-hydroxistyrol) mit den entsprechenden stöchiometrischen Mengen Pyrokohlensäure-dialkylester, Chlorkohlensäure-alkylester oder Imidazol-N-carbonsäurealkylester hergestellt werden, wobei die Alkylgruppen dieser Verbindungen jeweils 5 bis 9 C-Atome aufweisen.
   Besonders die tertiären Alkohole lassen sich bevorzugt nach der letztgenannten Methode umsetzen, indem zuerst analog einem Verfahren von H. Staab in Angew. Chemie, 12, Seite 407-423 (1962), die Imidazol-N-Carbonsäurealkylester hergestellt und diese dann bei erhöhter Temperatur, gegebenenfalls mit katalytischen Mengen Alkoholat oder Imidazolnatrium, in einer polymeranalogen Umsetzung mit beispielsweise Poly-p-hydroxystyrol oder Poly-p-hydroxy-α-methylstyrol umgesetzt werden.
   Die Umsetzung mit Chlorkohlensäurealkylestern wird üblicherweise in Gegenwart von Basen, z.B. Pyridin, nach bekannten Verfahren durchgeführt.
   Zur Einführung der Alkylcarbonatgruppe mit 5 bis 9 Kohlenstoffatomen in der Alkylgruppe kann weiterhin beispielsweise Poly-(p-hydroxystyrol) mit der entsprechenden stöchiometrischen Menge Pyrokohlensäure-dialkylester umgesetzt werden, wobei Poly-(p-hydroxistyrol) in Tetrahydrofuran gelöst und mit der entsprechenden Menge Kalium-t-butylat versetzt wird und anschließend beispielsweise der Pyrokohlensäure-t-amylester, gelöst in Tetrahydrofuran, zugetropft wird. Das erfindungsgemäße Polymere kann durch Fällen in Wasser gewonnen und durch mehrmaliges Umfällen gereinigt werden.
   Erfindungsgemäß enthält das polymere Bindemittel (a) 5 bis 40, vorzugsweise 10 bis 30 Mol.% Monomereineinheiten mit 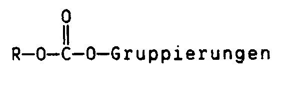 einpolymerisiert oder einkondensiert oder die 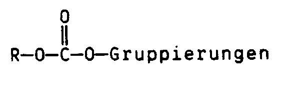 in entsprechender Menge durch polymeranaloge Umsetzung eingeführt.
   Die Zusammensetzung der Copolymeren wird zweckmäßigerweise durch thermogravimetrische Analyse und H-NMR-Spektroskopie bestimmt.
   Die Erfindung ist nicht auf die oben erwähnten Copolymeren beschränkt, vielmehr können alle alkalilöslichen Copolymere von p-Hydroxistyrol verwandt werden, welche erfindungsgemäß hydrophobe Comonomere mit 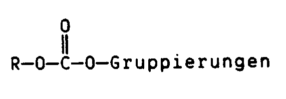 enthalten, bevorzugt sind jedoch solche, die als weitere Comonomereinheit ein p-Hydroxistyrolderivat enthalten, in welchem die phenolische OH-Gruppe mit Alkylcarbonaten geschützt ist, wobei der Alkylrest 5 bis 9 Kohlenstoffatome enthält.
   Das polymere Bindemittel (a) ist im erfindungsgemäßen strahlungsempfindlichen Gemisch im allgemeinen in einer Menge von 70 bis 98, vorzugsweise 80 bis 95 Gew.%, bezogen auf die Gesamtmenge von (a) + (b) enthalten.
(b) Als organische Verbindungen (b) sind solche bevorzugt, welche mindestens eine Sulfoniumsalzgruppierung und mindestens eine t-Butylcarbonatgruppierung oder mindestens eine Silylethergruppierung enthalten. Es können jedoch auch andere Verbindungen verwandt werden, welche unter Bestrahlung eine starke Säure bilden und im gleichen Molekül eine säurespaltbare Bindung enthalten.
   Bevorzugte organische Verbindungen (b) sind solche der allgemeinen Formel (I) 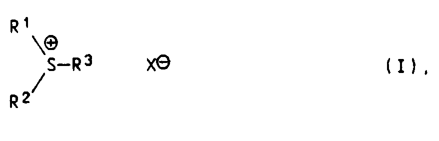 worin R¹, R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält, wobei einer der Reste R¹ bis R³ mit einem oder mehreren weiteren Sulfoniumsalzresten, gegebenenfalls über durch Säure spaltbare Gruppierungen, verknüpft sein kann und X^{⊖} ein nichtnucleophiles Gegenion bedeutet, wie z.B. Dimethyl-4-t-butoxicarbonyloxiphenyl-sulfoniumsalz mit Hexafluoroarsenat, Hexafluoroantimonat, Hexafluorophosphat und/oder Hexafluoroborat als Gegenion, Phenyl-bis-(4-t-butoxicarbonyloxiphenyl)-sulfonsiumsalz mit den genannten Gegenionen, Tris-(4-t-butoxicarbonyloxiphenyl)-sulfoniumsalz mit den genannten Gegenionen, 4-Hydroxiphenyl-bis-(4-t-butoxicarbonyloxiphenyl)-sulfoniumsalz mit den genannten Gegenionen oder 1-Naphthyl-4-trimethylsilyloxitetramethylen-sulfoniumsalz mit den genannten Gegenionen.
   Besonders bevorzugte derartige organische Verbindungen (b) sind solche der allgemeinen Formel (IV) 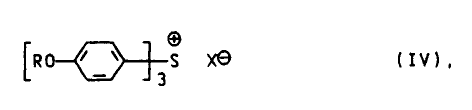 worin R = H, t-Butoxicarbonyl- und/oder Trialkylsilyl sein kann, mit der Maßgabe, daß mindestens einer der Reste R ≠ H ist.

Die Synthese der organischen Verbindungen (b) ist beispielsweise in DE-A-37 21 741 bzw. DE-A-37 21 740 beschrieben.

Komponente (b) ist im erfindungsgemäßen strahlungsempfindlichen Gemisch im allgemeinen in einer Menge von 2 bis 30, vorzugsweise 5 bis 20 Gew.%, bezogen auf die Summe der Gewichtsprozente von (a) und (b) enthalten.

Die erfindungsgemäßen strahlungsempfindlichen Gemische sind sensitiv gegenüber Röntgen-, Elektronen- und UV-Strahlung. Gegebenenfalls können Sensibilisatoren in geringen Mengen zugesetzt werden, wie beispielsweise Pyren und Perylen, um die Verbindungen im längerwelligen UV- bis hin zum sichtbaren Wellenlängenbereich zu sensibilisieren. Für die Belichtung in speziellen Wellenlängenbereichen, wie beispielsweise im kurzwelligen UV (< 300 nm), ist eine hohe Transparenz der Schichten bei der jeweiligen Belichtungswellenlänge gefordert. In gängigen Belichtungsgeräten auf Basis von Quecksilberlampen nutzt man die 254 nm Linie oder man verwendet Excimer-Laser, die bei 248 nm (KrF) emittieren. Strahlungsempfindliche Aufzeichnungsmaterialien sollten deshalb in diesem Bereich möglichst niedrige optische Dichten aufweisen.

Mit den erfindungsgemäß einzusetzenden alkalilöslichen Bindemitteln, die 5 bis 40 Mol.% hydrophobe Comonomere mit C₅- bis C₉-Alkylcarbonatgruppierungen enthalten, lassen sich niedrige optische Dichten im Wellenlängenbereich um 250 nm einstellen, da man den Anteil der löslichkeitsinhibierenden Komponenten (b), beispielsweise im Vergleich zu Poly-p-hydroxistyrol ohne seitenständige hydrophobe Gruppen reduzieren kann.

Der Massenverlust ist gegenüber den in US-A-4 491 628 beschriebenen Polymeren wesentlich reduziert.

Der Anteil der hydrophoben Monomereinheit läßt sich in besonders vorteilhafter Weise auf Anteile deutlich unter 40 % verringern, wenn die hydrophoben C₅-C₉-Alkylcarbonatgruppierungen sterisch anspruchsvolle Alkoholreste, wie z.B. t-Amyl-, Cyclohexyl-, Methylhexyl- oder Methylpentyl- enthalten.

Bei dem erfindungsgemäßen Verfahren zur Herstellung von Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche nach einem thermischen Ausheizschritt bei Temperaturen zwischen 60°C und 120°C in wäßrig-alkalischen Lösungsmitteln zunimmt und diese Bereiche selektiv mit dem alkalischen Entwickler entfernt werden können.

Vorzugsweise wird z.B. das polymere Bindemittel (a) und zwischen 2 bis 30 Gew.%, besonders bevorzugt zwischen 5 und 20 Gew.% einer Verbindung des Typs (b), bezogen auf das Gesamtgewicht der Verbindungen (a) und (b), in Methylglykolacetat oder Methyl-propylenglykol-acetat gelöst, wobei der Feststoffgehalt der Lösung zweckmäßigerweise zwischen 10 und 30 Gew.% beträgt. Die Lösung kann durch ein Filter mit einem Porendurchmesser von 0,2 µm filtriert werden. Durch Aufschleudern dieser Resistlösung bei Umdrehungszahlen zwischen 1000 und 10 000 U/Minute kann ein Resistfilm auf dem Wafer erzeugt werden. Der Wafer wird dann vorzugsweise zwischen 1 und 5 Minuten bei 90°C bzw. 80°C ausgeheizt. Die Filme können dann durch eine chrombeschichtete strukturierte Quarzmaske mit UV-Licht einer Quecksilberlampe, mit Excimer-Laserlicht, Elektronen- oder Röntgenstrahlen bestrahlt und die bestrahlten Filme zwischen 5 Sekunden und 2 Minuten bei Temperaturen zwischen 60°C und 120°C ausgeheizt werden. Die so behandelten Filme werden hierauf mit alkalischen, gegebenenfalls Alkohole enthaltenden Entwicklern entwickelt, wobei sich die belichteten Bereiche selektiv ablösen, während in den unbelichteten Bereichen nur wenig Abtrag stattfindet.

Die in den Beispielen und Vergleichsbeispielen genannten Teile und Prozente sind, soweit nicht anders angegeben, Gewichtsteile und Gewichtsprozente.

### Beispiel 1

Eine Photoresistlösung wird aus 10 Teilen Tris-(4-t-butoxicarbonyloxiphenyl-)sulfoniumhexafluoroarsenat, 90 Teilen eines Copolymerisats aus 70 Mol.% p-Hydroxistyrol und 30 Mol.% p-tert.-Amyloxicarbonyloxistyrol (M̅_{w} (Lichtstreuung) 65 000 g/mol) und 400 Teilen Methylpropylenglykolacetat hergestellt. Die Lösung wird durch ein Filter mit einem Porendurchmesser von 0,2 µm filtriert und auf einen Siliziumwafer mit einem SiO₂-Film in einer Schichtdicke von ca. 1,0 µm (trocken) aufgeschleudert. Der Wafer wird eine Minute bei 90°C getrocknet und anschließend mit einer bildmäßig strukturierten Testmaske im Kontaktverfahren 3 Sekunden mit Excimer-Laserlicht der Wellenlänge 248 nm belichtet. Danach wird 60 Sekunden bei 80°C ausgeheizt und mit einem Entwickler vom pH-Wert 13,00 30 Sekunden entwickelt. Die belichteten Bereiche sind vollständig abgetragen, während kein Abtrag der unbelichteten Bereiche mit einem Profilometer (α-step der Fa. Tencor) meßbar ist. Die Resistmuster zeigen vertikale Flanken.

### Vergleichsbeispiel 1

Eine Photoresistlösung wird aus 10 Teilen Tris-(4-t-butoxicarbonyloxi-phenyl-)sulfoniumhexafluoroarsenat, 90 Teilen Poly-(p-hydroxistyrol) (M̅_{w} (Lichtstreuung) 62 000 g/mol) und 400 Teilen Methylpropylenglykolacetat hergestellt. Es wird wie in Beispiel 1 verfahren. Die belichteten Bereiche lassen sich auch hier während der 30 Sekunden Entwicklungszeit vollständig abtragen, jedoch findet ein erheblicher Abtrag der unbelichteten Bereiche (52 %) statt.

Um den Abtrag in den unbelichteten Bereichen zu reduzieren, kann man den Anteil der Sulfoniumsalze erhöhen. Daher wurde eine Photoresistlösung aus 20 Teilen Tris-(4-t-butoxicarbonyloxiphenyl)-sulfoniumhexafluoroarsenat, 80 Teilen Poly-(p-hydroxistyrol) und 300 Teilen Methyl-propylenglykolacetat hergestellt. Die optische Dichte einer 1 µm dicken Schicht beträgt 1,05. Es wird wie in Beispiel 1 verfahren, jedoch muß man 11 Sekunden belichten, um die belichteten Bereiche unter den gleichen Bedingungen vollständig abzutragen. Die Resistprofile weisen außerdem schräge Kanten auf.

### Vergleichsbeispiel 2

Dieses Vergleichsbeispiel zeigt, daß die Verwendung von kommerziell erhältlichen Sulfoniumsalzen (ohne säurelabile Gruppen), ebenfalls nicht die erwünschte Reduzierung des Dunkelabtrages auf Werte kleiner 5 % erfüllt.

Eine Photoresistlösung wird aus 10 Teilen Triphenylsulfoniumhexafluoroarsenat, 90 Teilen des in Beispiel 1 genannten Poly-(p-hydroxistyrol-co-30 Mol.% t-amyloxicarbonyloxistyrol) und 400 Teilen Methylpropylenglykolacetat hergestellt. Die Lösung wird durch ein Filter mit einem Porendurchmesser von 0,2 µm filtriert und auf einen Siliziumwafer mit einem SiO₂-Film in einer Schichtdicke von 1,03 µm aufgeschleudert. Der Wafer wird eine Minute bei 90°C getrocknet und dann mit einem Entwickler vom pH-Wert 13,0 während 30 Sekunden behandelt. Es findet erheblicher Abtrag der unbelichteten Bereiche (26 %) statt.

### Beispiel 2

Eine Photoresistlösung wird aus 10 Teilen Tris-(4-t-butoxicarbonyloxiphenyl-)sulfoniumhexafluorophosphat, 90 Teilen eines Copolymeren aus 80 Mol.% p-Hydroxistyrol und 20 Mol.% p-2-Methyl-hexyl-2-oxi-carbonyloxistyrol (K-Wert nach Fikentscher (gemessen in Ethylacetat): 30,5) und 400 Teilen Methylpropylenglykolacetat hergestellt und durch einen Filter mit der Porenweite 0,2 µm filtriert. Die Photoresistlösung wird auf einen Siliziumwafer aufgeschleudert, so daß eine Schichtdicke von ca. 1 µm resultiert. Anschließend wird der Wafer 5 Minuten bei 80°C ausgeheizt und mit einer strukturierten Testmaske im Kontaktverfahren während 10 Sekunden mit Excimer-Laserlicht der Wellenlänge 248 nm belichtet. Man heizt anschließend 60 Sekunden bei 80°C aus und entwickelt dann während 60 Sekunden mit einem alkalischen Entwickler vom pH-Wert 12,5. Es werden gute Resiststrukturen erhalten, wobei kein Abtrag der unbelichteten Bereiche meßbar ist.

### Beispiel 3

Eine Photoresistlösung wird hergestellt, indem man 10 Teile Tris-(4-t-butoxicarbonyloxiphenyl-)sulfoniumhexafluoroarsenat und 90 Teile eines Copolymeren aus 75 Mol.% p-Hydroxistyrol und 25 Mol.% p-Cyclohexyloxicarbonyloxistyrol (K-Wert nach Fikentscher (gemessen in Ethylacetat): 26) in 400 Teilen Ethyl-cellosolve-acetat löst und durch ein Filter mit der Porenweite 0,2 µm filtriert.

Die Resistlösung wird auf einen Siliziumwafer aufgeschleudert, so daß eine Schichtdicke von 1 µm resultiert. Es wird 5 Minuten bei 80°C ausgeheizt und dann durch eine Testmaske im Kontaktverfahren 3 Sekunden mit Excimer-Laserlicht der Wellenlänge 248 nm belichtet. Nach dem Ausheizen während 60 Sekunden bei 90°C wird 30 Sekunden mit einem alkalischen Entwickler vom pH 12,10 entwickelt. Die belichteten Bereiche sind vollständig abgetragen, während der Abtrag der unbelichteten Flächen unter 2 % beträgt.

### Beispiel 4

Es wird wie in Beispiel 3 verfahren, jedoch wird als Polymer ein Copolymer aus 88 Mol.% p-Hydroxystyrol und 12 Mol.% p-(t-Amyloxicarbonyloxi)-styrol (M̅_{w} (Lichtstreuung) 45 000 g/mol) eingesetzt. Der Abtrag der unbelichteten Bereiche beträgt ca. 7 %. Es werden Resistmuster guter Qualität erhalten.

## Patentansprüche

1. Strahlungsempfindliches Gemisch, enthaltend
(a) ein in Wasser unlösliches, in wäßrig-alkalischen Lösungen lösliches polymeres Bindemittel und
(b) eine organische Verbindung, deren Löslichkeit in einem wäßrigalkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure bildet, enthält,
dadurch gekennzeichnet, daß das polymere Bindemittel (a) 5 bis 40 Mol.% Monomereneinheiten mit 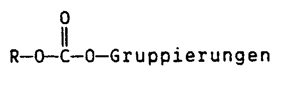 einpolymerisiert bzw. einkondensiert oder die 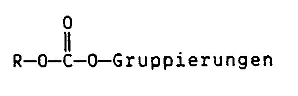 durch polymeranaloge Umsetzung eingeführt enthält, mit der Maßgabe, daß der Rest R 5 bis 9 Kohlenstoffatome enthält, und als organische Verbindung (b) ein Sulfoniumsalz der allgemeinen Formel (I) 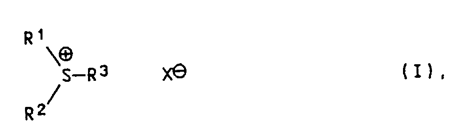 worin R¹, R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält, wobei einer der Reste R¹ bis R³ mit einem oder mehreren weiteren Sulfoniumsalzresten, gegebenenfalls über durch Säure abspaltbare Gruppierungen, verknüpft sein kann, und X^{⊖} ein nichtnukleophiles Gegenion bedeutet, eingesetzt wird.

2. Strahlungsempfindliches Gemisch nach Anspruch 1, dadurch gekennzeichnet, daß als polymeres Bindemittel (a) Poly-(p-hyroxistyrol), Poly-(p-hydroxi-α-methylstyrol) oder Copolymere von p-Hydroxistyrol und p-Hydroxi-α-methylstyrol eingesetzt werden, mit der Maßgabe, daß 5 bis 40 Mol.% der p-Hydroxi(-α-methyl)styroleinheiten an Stelle der phenolischen Hydroxylgruppe einen C₅- bis C₉-Alk(en)yloxicarbonyloxirest tragen.

3. Strahlungsempfindliches Gemisch nach Anspruch 1, dadurch gekennzeichnet, daß als polymeres Bindemittel (a) Novolake auf Basis von p-Kresol und Formaldehyd eingesetzt werden, worin 5 bis 40 Mol.% der einkondensierten p-Kresoleinheiten durch Gruppierungen der Formel 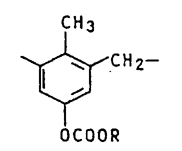 ersetzt sind, und R für einen Alkyl-, Alkenyl-, Alkinyl, Cycloalkyl- oder Cycloalkenylrest mit jeweils 5 bis 9 Kohlenstoffatomen steht.

4. Verfahren zur Herstellung von Reliefmustern und Reliefbildern, dadurch gekennzeichnet, daß man als lichtempfindliche Beschichtungsmaterialien ein strahlungsempfindliches Gemisch gemäß einem der vorhergehenden Ansprüche einsetzt.

5. Verfahren zur Herstellung von Reliefmustern nach Anspruch 4, dadurch gekennzeichnet, daß nach der Belichtung des strahlungsempfindlichen Gemisches auf Temperaturen zwischen 60 und 120°C erhitzt wird.

## Claims

1. A radiation sensitive mixture comprising
(a) a polymeric binder which is insoluble in water but soluble in aqueous alkaline solutions and
(b) an organic compound whose solubility in an aqueous alkaline developer is increased by the action of acid and which contains at least one acid cleavable group and also a group which on irradiation forms a strong acid,
wherein the polymeric binder (a) contains from 5 to 40 mol % of monomer units having 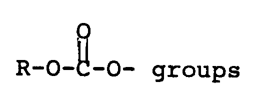 in copolymerized or cocondensed form or the 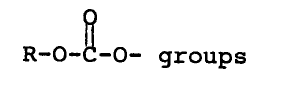 introduced by polymer analogous reaction, with the proviso that the radical R contains from 5 to 9 carbon atoms and the organic compound (b) used is a sulfonium salt of the general formula (I) 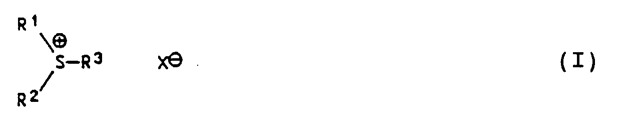 where R¹, R² and R³ are identical to or different from one another and each is singly acyclyl or aryl which may each contain heteroatoms, or two of R¹ to R³ together form a ring, with the proviso that at least one of R¹ to R³ contains at least one acid cleavable group, one of R¹ to R³ can be bonded to one or more further sulfonium salt residues directly or via acid cleavable groups, and X^{⊖} is a nonnucleophilic counterion.

2. A radiation sensitive mixture as claimed in claim 1, wherein the polymeric binder (a) is poly(p-hydroxystyrene), poly (p-hydroxy-α-methylstyrene) or a copolymer of p-hydroxystyrene and p-hydroxy-α-methylstyrene, with the proviso that from 5 to 40 mol % of the p-hydroxy(α-methyl)styrene units carry a C₅-C₉-alk(en)yloxycarbonyloxy radical in place of the phenolic hydroxyl group.

3. A radiation sensitive mixture as claimed in claim 1, wherein the polymeric binder (a) used is a novolak based on p-cresol and formaldehyde in which from 5 to 40 mol % of the cocondensed p-cresol units have been replaced by groups of the formula 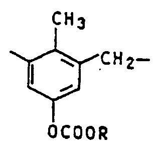 where R is alkyl, alkenyl, alkynyl, cycloalkyl or cycloalkenyl each of from 5 to 9 carbon atoms.

4. A process for producing relief patterns and relief images, which comprises using as the light sensitive coating material a radiation sensitive mixture as claimed in any of the preceding claims.

5. A process for producing relief patterns as claimed in claim 4, wherein irradiation of the radiation sensitive mixture is followed by heating at from 60 to 120°C.

## Revendications

1. Mélange sensible aux rayonnements, qui contient
(a) un liant polymérique insoluble dans l'eau, soluble dans des solutions aqueuses-alcalines et
(b) un composé organique dont la solubilité dans un révélateur aqueux-alcalin est augmentée sous l'effet d'un acide et qui contient au moins un groupement pouvant être scindé ou séparé par un acide, comme complémentairement aussi un groupement qui forme un acide fort sous l'influence d'un rayonnement,
caractérisé en ce que le liant polymérique (a) contient 5 à 40% molaires d'unités monomériques avec des groupements 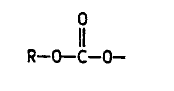 incorporés par polymérisation ou condensation, ou qui contient les groupements 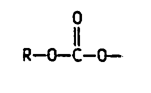 incorporés par une réaction analogue à celle de polymères, avec la condition que le radical R contienne de 5 à 9 atomes de carbone et en ce que l'on utilise, à titre de composé organique (b), un sel de sulfonium de la formule générale (I) 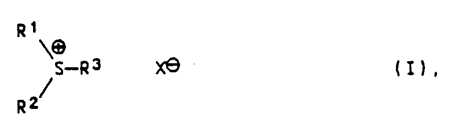 dans laquelle R¹, R² et R³ sont mutuellement identiques ou différents et représentent des radicaux aliphatiques et/ou aromatiques, qui contiennent éventuellement des hétéroatomes, ou bien deux des symboles R¹ à R³ sont mutuellement liés en un cycle, avec la condition qu'au moins l'un des symboles R¹ à R³ contienne au moins un groupement pouvant être scindé ou séparé par un acide, où l'un des symboles R¹ à R³ peut être lié avec un ou plusieurs groupes sel de sulfonium supplémentaires, éventuellement par l'intermédiaire de groupements qui peuvent être scindés ou séparés par un acide et X^{⊖} représente un ion associé qui n'est pas nucléophile.

2. Mélange sensible aux rayonnements suivant la revendication 1, caractérisé en ce qu'à titre de liant polymérique (a), on utilise du poly-(p-hydroxystyrène), du poly-(p-hydroxy-alpha-méthylstyrène), ou des copolymères du p-hydroxystyrène et du p-hydroxy-alpha-méthylstyrène, avec la condition que de 5 à 40% molaires des unités p-hydroxy-(alpha-méthylstyrène) portent un radical alc(én)yl(C₅-C₉)oxycarbonyloxy au lieu du radical hydroxyle phénolique.

3. Mélange sensible aux rayonnements suivant la revendication 1, caractérisé en ce qu'à titre de liant polymérique (a), on utilise des novolaques à base de p-crésol et du formaldéhyde, où 5 à 40% molaires des unités p-crésol incorporées par condensation sont remplacées par des groupements de la formule 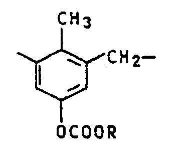 et R représente un radical alkyle, alcényle, alcynyle, cycloalkyle ou cycloalcényle, qui comporte à chaque fois de 5 à 9 atomes de carbone.

4. Procédé de fabrication d'images en relief et de modèles en relief, caractérisé en ce que l'on utilise, à titre de matériau de revêtement photosensible, un mélange sensible aux rayonnements selon l'une quelconque des revendications précédentes.

5. Procédé de fabrication de modèles en relief suivant la revendication 4, caractérisé en ce qu'après l'exposition du mélange sensible aux rayonnements, on le porte à des températures comprises entre 60 et 120°C.
